# EUROPEAN PATENT SPECIFICATION

(11) **EP 4 369 012 B1**
(45) Date of publication and mention of the grant of the patent: **03.06.2026**
(21) Application number: 23203532.9
(22) Date of filing: 13.10.2023
(51) Int. Cl.: G01R 31/367, G01R 31/392

(54) **INFORMATION PROCESSING DEVICE, INFORMATION PROCESSING METHOD, AND COMPUTER-READABLE STORAGE MEDIUM**
INFORMATIONSVERARBEITUNGSVORRICHTUNG, INFORMATIONSVERARBEITUNGSVERFAHREN UND COMPUTERLESBARES SPEICHERMEDIUM
DISPOSITIF DE TRAITEMENT D'INFORMATIONS, PROCÉDÉ DE TRAITEMENT D'INFORMATIONS ET SUPPORT D'INFORMATIONS LISIBLE PAR ORDINATEUR

(30) Priority: 09.11.2022 JP 2022179865
(43) Date of publication of application: 15.05.2024
(73) Proprietor: TOYOTA JIDOSHA KABUSHIKI KAISHA, Toyota-shi, Aichi-ken, 471-8571 (JP)
(72) Inventor: SAYO, Takashi, Toyota-shi, 471-8571 (JP); NATE, Hiroshi, Toyota-shi, 471-8571 (JP)
(74) Representative: J A Kemp LLP

(56) References cited:
- EP-A1- 3 611 524
- US-A1- 2016 231 390
- US-A1- 2020 384 884
- US-A1- 2022 317 189

## Description

### BACKGROUND

### Technical Field

The present disclosure relates to an information processing device, an information processing method, and a computer-readable storage medium that keep down the amount of data that is the subject in estimating the state of a battery.

### Related Art

Japanese Patent Application Laid-Open (JP-A) No. 2022-044943 (Patent Document 1) discloses a battery system that estimates the capacity retention of a battery by using an estimation model carrying out machine learning using, as teacher data, a usage pattern relating to the temperature, the current and the charge capacity of the battery, and a measured value of the capacity deterioration rate per unit time of the battery.

JP-A No. 2020-148560 (Patent Document 2) discloses a life predicting device that predicts the remaining life of a battery that is the object of prediction, by using a learned model that has learned the remaining lives of batteries on the basis of learning data including remaining lives and time series data of deterioration indices at past, predetermined points in time of batteries.

JP-A No. 2017-004955 (Patent Document 3) discloses a battery state estimation device estimating the pack status for an entire battery pack by simplifying the battery pack, which includes plural battery cells, into a single battery cell.

JP-A No. 2016-085062 (Patent Document 4) discloses a battery deterioration judging device that measures the AC impedance characteristic of a lithium secondary battery having an electrolytic layer including a positive electrode, a negative electrode and a separator, and expresses the AC impedance characteristic by an artificial electronic equivalent circuit, and judges the formation of dendrites from the change in the resistance value derived from the negative electrode and from the change in the capacitor.

By the way, at a server that estimates the state of a battery installed in a vehicle, when state information relating to the state of the battery is collected from plural vehicles, the amount of data may become huge. Therefore, when carrying out processing on the collected state information in order to judge the state of a battery, there are the concerns that the computing costs will be huge, and that this will lead to delays in processing.

US 2020/384884 A1 discloses a battery state determining system that includes an in-vehicle device and a server. The in-vehicle device includes: an acquisition unit acquiring physical quantity data representing a physical quantity relating to a state of a battery mounted in a vehicle; a determination unit executing a determination process of determining whether or not the physical quantity represented by the physical quantity data satisfies a predetermined condition; and a transmission unit transmitting the physical quantity data to the server in a case in which it is determined that the physical quantity represented by the physical quantity data satisfies the predetermined condition in the determination process. The server includes: a reception unit receiving the physical quantity data from the in-vehicle device; and a diagnosis unit executing a diagnosis process of diagnosing an abnormality of the battery based on the physical quantity data and generating diagnosis result data representing a result of the diagnosis process.

### SUMMARY

An object of the present disclosure is to provide an information processing device, an information processing method, and a computer-readable storage medium that can keep computing costs down in cases of estimating the state of a battery.

An information processing device relating to a first aspect is defined in claim 1.

The information processing device relating to the first aspect acquires state information expressing the state of the battery installed in a vehicle. In a case in which state information satisfies a predetermined condition, the information processing device extracts the state information that satisfies the condition, as subject data. Namely, in accordance with this information processing device, of the acquired state information, the state information that satisfies a predetermined condition is extracted as subject data. Due thereto, computing costs can be suppressed when estimating the state of the battery.

In a first form of the information processing device relating to the first aspect, the acquiring section acquires the state information that includes a number of times of starting in which the vehicle was started and set in an on state, and an activated time period over which the vehicle was in the on state, and the judging section judges that the state information satisfies the predetermined condition when at least one of a case in which the number of times of starting relating to the state information is greater than or equal to a first threshold value, and a case in which the activated time period relating to the state information is greater than or equal to a second threshold value, is satisfied.

In accordance with the first form of the information processing device relating to the first aspect, state information at a battery, which is in a condition in which it is difficult for load to be applied thereto, can be excluded from the subject data.

In the first form of the information processing device relating to the first aspect, the first threshold value is set such that, the greater the activated time period included in the state information, the greater the first threshold value, and the second threshold value is set such that, the greater the number of times of starting included in the state information, the greater the second threshold value.

In accordance with the first form of the information processing device relating to the first aspect, state information of the battery can be excluded from the subject data more appropriately, in accordance with the extent to which it is difficult for load to be applied to the battery.

In a second form of the information processing device relating to the first aspect, the acquiring section acquires, as the state information, lowest voltages outputted by the battery at times when the vehicle was started, and, in a case in which an index, which expresses a degree of dispersion in the lowest voltages, is greater than or equal to a third threshold value, the judging section judges that the state information satisfies the predetermined condition.

In accordance with the second form of the information processing device relating to the first aspect, state information can be extracted in consideration of the unstable state of the battery, such as the charge capacity, the allowable charge amount, and the like.

An information processing device relating to a second aspect is defined in claim 2.

In accordance with the information processing device relating to the second aspect, the unstable state of the battery is clarified, and the state information can be extracted.

An information processing device relating to a third aspect is defined in claim 3.

In accordance with the information processing device relating to the third aspect, by using the learned model that has learned past state information, state information can be extracted on the basis of state information that was acquired in the past.

An information processing device relating to a fourth aspect is defined in claim 4.

In accordance with the information processing device relating to the fourth aspect, it can be judged whether or not the state information satisfies a condition, while reflecting data that was acquired in the past.

An information processing method relating to a fifth aspect is defined in claim 5.

The information processing method relating to the fifth aspect acquires state information expressing the state of the battery installed in a vehicle. In a case in which state information satisfies a predetermined condition, the information processing method extracts the state information that satisfies the condition, as subject data. Namely, in accordance with this information processing method, of the acquired state information, the state information that satisfies a predetermined condition is extracted as subject data. Due thereto, computing costs can be suppressed when estimating the state of the battery.

An information processing program relating to a sixth aspect is defined in claim 6.

A computer, which executes the information processing program relating to the sixth aspect, acquires state information expressing the state of the battery installed in a vehicle. In a case in which state information satisfies a predetermined condition, the computer extracts the state information that satisfies the condition, as subject data. Namely, in accordance with this computer, of the acquired state information, the state information that satisfies a predetermined condition is extracted as subject data. Due thereto, computing costs can be suppressed when estimating the state of the battery.

In accordance with the present disclosure, computing costs can be kept down in cases of estimating the state of a battery.

### BRIEF DESCRIPTION OF THE DRAWINGS

Fig. 1 is a drawing illustrating the schematic structure of an information processing system relating to embodiments;
Fig. 2 is a block drawing illustrating hardware structures of a vehicle of the embodiments;
Fig. 3 is a block drawing illustrating functional structures of an onboard device of the embodiments;
Fig. 4 is a block drawing illustrating hardware structures of a central server of the embodiments;
Fig. 5 is a block drawing illustrating functional structures of the central server of the first embodiment;
Fig. 6 is a graph provided for explaining threshold values of the embodiments, and illustrating the relationship between number of times of starting and activated time period;
Fig. 7 is a flowchart illustrating the flow of processing of extracting subject information, which processing is executed at the central server of the first embodiment;
Fig. 8 is a block drawing illustrating functional structures of the central server of the second embodiment;
Fig. 9 is a flowchart illustrating the flow of processing of extracting subject information, which processing is executed at the central server of the second embodiment;
Fig. 10 is a block drawing illustrating functional structures of the central server of the third embodiment;
Fig. 11 is a flowchart illustrating the flow of processing of extracting subject information, which processing is executed at the central server of the third embodiment; and
Fig. 12 is a flowchart illustrating the flow of processing of generating a learned model, which processing is executed at the central server of the third embodiment.

### DETAILED DESCRIPTION

### [First Embodiment]

An information processing system that includes an information processing device of the present disclosure is described. The information processing system is a system that, by using information (hereinafter called "state information") relating to the state of a battery installed in a vehicle, which information is acquired from an onboard device installed in the vehicle, extracts subject data for diagnosing the state of the battery. Note that description is given of a form in which the vehicle relating to the present embodiments is an engine powered vehicle in which an engine is installed. However, the present disclosure is not limited to this, and the vehicle may be an electric vehicle (EV), a hybrid vehicle (HEV), or a fuel cell vehicle (FCV).

### (Overall Structure)

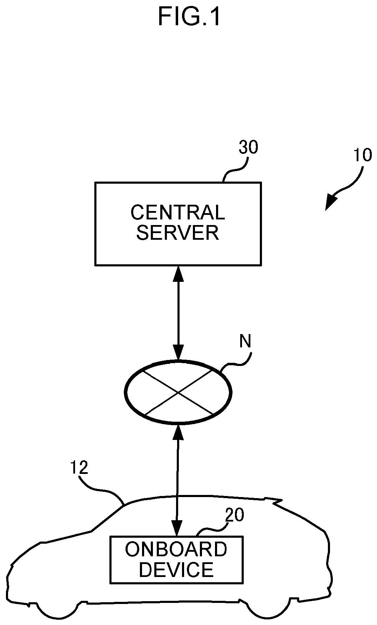

As illustrated in Fig. 1, an information processing system 10 of embodiments of the present disclosure is structured to include a vehicle 12 and a central server 30 serving as the information processing device. An onboard device 20 is installed in the vehicle 12. The onboard device 20 and the central server 30 are connected to one another through network N.

Note that, although Fig. 1 illustrates the one vehicle 12, which includes the onboard device 20, with respect to the one central server 30, the numbers of the vehicle 12, the onboard device 20 and the central server 30 are not limited to these.

The onboard device 20 is a device that acquires state information relating to the vehicle 12 and transmits the state information to the central server 30. Here, the state information relating to the present embodiment is data relating to the state of the battery that is detected from respective equipment installed in the vehicle 12. For example, the state information relating to the present embodiment are data including the number of times that the ignition has been set in an on state in order to start the engine by using the battery (hereinafter called the "number of times of starting"), the durations from the ignition being set in the on state until the engine is set in the off state (hereinafter called the "activated time period"), and the lowest voltages that the battery outputted.

The central server 30 is disposed, for example, at the manufacturer that manufactured the vehicle 12 or at a car dealer associated with that manufacturer. The central server 30 acquires the state information from the onboard device 20, and, from the acquired state information, extracts subject data for diagnosing the state of the battery. Note that the extracted subject data may be transmitted to an external device that diagnoses the state of the battery, or may be stored as subject data.

### (Vehicle)

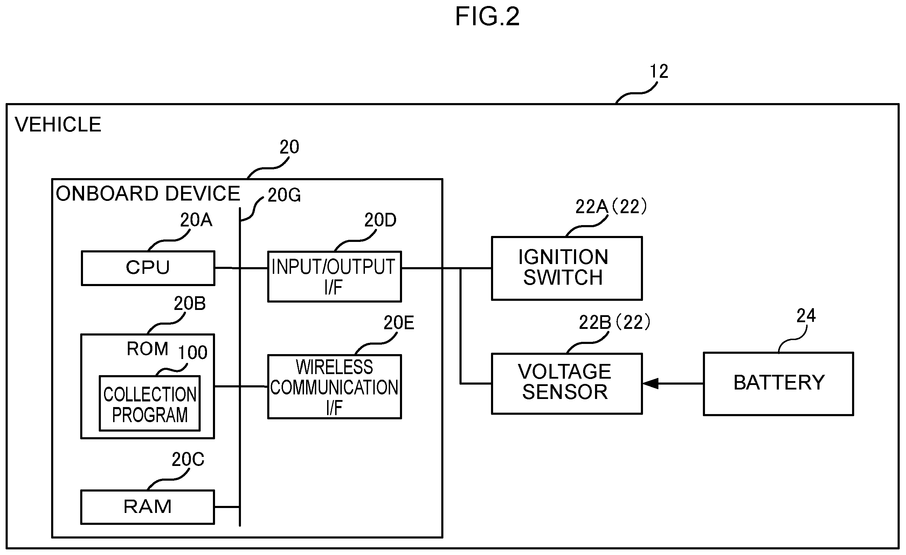

As illustrated in Fig. 2, the vehicle 12 relating to the present embodiment is structured to include the onboard device 20, plural onboard equipment 22, and a battery 24.

The onboard device 20 is structured to include a CPU (Central Processing Unit) 20A, a ROM (Read Only Memory) 20B, a RAM (Random Access Memory) 20C, an input/output I/F (Interface) 20D, and a wireless communication I/F 20E. The CPU 20A, the ROM 20B, the RAM 20C, the input/output I/F 20D, and the wireless communication I/F 20E are connected so as to be able to communicate with one another via an internal bus 20G.

The CPU 20A is a central computing processing unit, and executes various programs and controls respective sections. Namely, the CPU 20A reads-out a program from the ROM 20B, and executes the program by using the RAM 20C as a workspace.

The ROM 20B stores various programs and various data. A collection program 100, which carries out collecting of state information of the vehicle 12 from the onboard equipment 22, is stored in the ROM 20B of the present embodiment. Accompanying the execution of the collection program 100, the onboard device 20 executes processing that transmits the state information to the central server 30. The RAM 20C temporarily stores programs and data as a workspace.

The input/output I/F 20D is an interface for communicating with the onboard equipment 22. The input/output I/F 20D is connected to an ignition switch 22A and a voltage sensor 22B that serve as the onboard equipment 22. The ignition switch 22A outputs a signal expressing that the engine has been set in an on state in order to start the engine. At the time when the engine starts, the voltage sensor 22B detects the voltage outputted by the battery 24, and outputs a signal expressing the voltage value to the onboard device 20 as results of detection.

The wireless communication I/F 20E is a wireless communication module for communicating with the central server 30. Communication standards such as, for example, 5G, LTE, Wi-Fi^{™}, or the like are used at this wireless communication module. The wireless communication I/F 20E is connected to the network N.

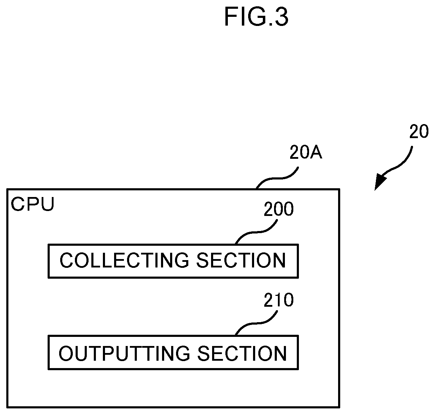

As illustrated in Fig. 3, at the onboard device 20 of the present embodiment, due to the CPU 20A executing the collection program 100, the CPU 20A functions as a collecting section 200 and an outputting section 210.

The collecting section 200 has the function of collecting the state information outputted from the respective onboard equipment 22 of the vehicle 12. Here, the collecting section 200 collects, as the state information, the number of times of starting, the activated time period, and the lowest voltages at times of starting the engine.

The outputting section 210 has the function of outputting the state information, which was collected by the collecting section 200, to the central server 30 by using the wireless communication I/F 20E.

### (Central Server)

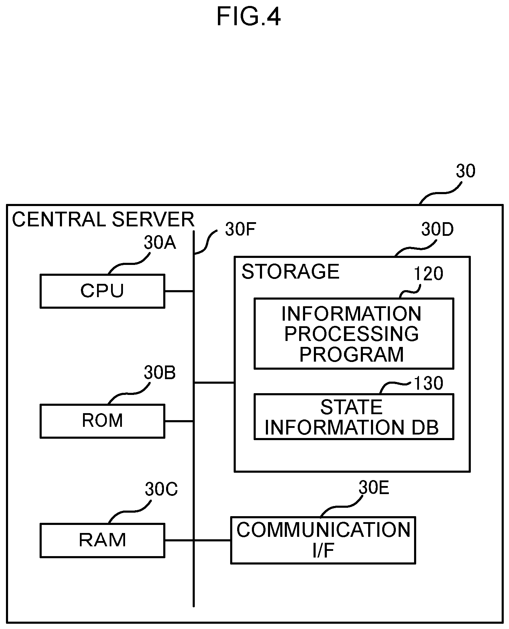

As illustrated in Fig. 4, the central server 30 is structured to include a CPU 30A, a ROM 30B, a RAM 30C, a storage 30D, and a communication I/F 30E. The CPU 30A, the ROM 30B, the RAM 30C, the storage 30D and the communication I/F 30E are connected so as to be able to communicate with one another via an internal bus 30F. The functions of the CPU 30A, the ROM 30B, the RAM 30C, and the communication I/F 30E are the same as those of the above-described CPU 20A, ROM 20B, RAM 20C, and wireless communication I/F 20E of the onboard device 20. Note that the communication I/F 30E may carry out communication by wires.

The storage 30D that serves as a recording medium is structured by an HDD (Hard Disk Drive) or an SSD (Solid State Drive), and stores various programs and various data. An information processing program 120 and a state information database (hereinafter called "state information DB") 130 are stored in the storage 30D of the present embodiment. Note that the ROM 30B may store the information processing program 120 and the state information DB 130.

The information processing program 120 that serves as the program is a program for controlling the central server 30. Accompanying the execution of the information processing program 120, the central server 30 executes various processings including a processing of acquiring state information and a processing of extracting subject data from the state information.

State information received from the onboard device, and subject data that is extracted, are stored in the state information DB 130.

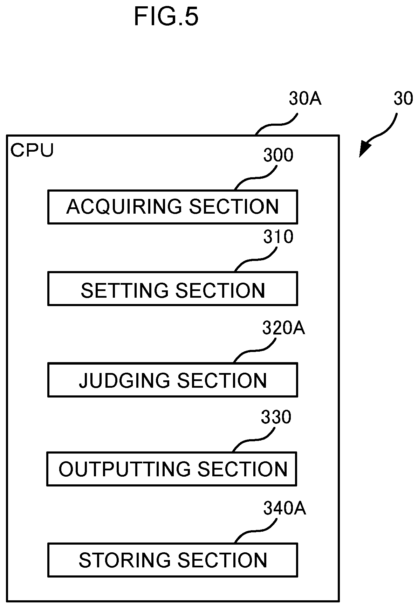

As illustrated in Fig. 5, at the central server 30 of the present embodiment, due to the CPU 30A executing the information processing program 120, the CPU 30A functions as an acquiring section 300, a setting section 310, a judging section 320A, an outputting section 330, and a storing section 340A.

The acquiring section 300 has the function of acquiring the state information transmitted from the onboard device 20 of the vehicle 12. Here, the acquiring section 300 relating to the present embodiment acquires state information including the number of times of starting, the activated time period, and the lowest voltages at times of starting the engine.

By using the state information, the setting section 310 sets a threshold value for the number of times of starting (hereinafter called the "threshold value relating to the number of times") and a threshold value for the activated time period (hereinafter called the "threshold value relating to the time period"). Here, the threshold value relating to the number of times is an example of the "first threshold value", and the threshold value relating to the time period is an example of the "second threshold value".

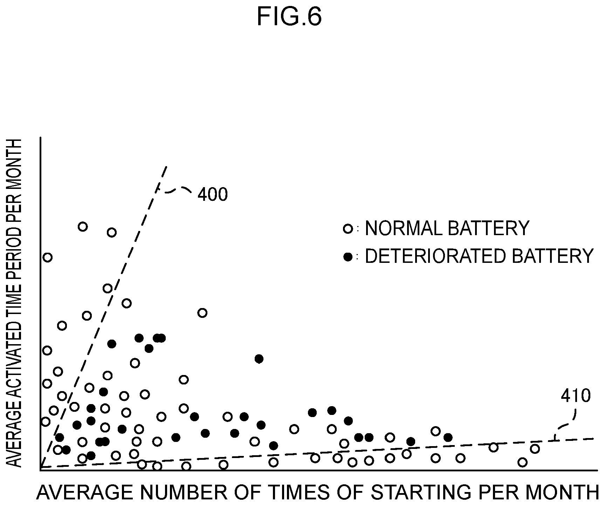

Here, Fig. 6 that is illustrated as an example is a graph showing the relationship between average number of times of starting per month and the average activated time period per month at a battery.

As illustrated as an example in Fig. 6, on the basis of state information of batteries that have deteriorated among battery information that has been acquired in the past, the setting section 310 sets the threshold values for the number of times of starting and the activated time period, respectively, that are included in the state information. Here, the setting section 310 sets a threshold value 400 relating to the number of times to be greater, the greater the activated time period that is included in the state information. Further, the setting section 310 sets a threshold value 410 relating to the time period to be greater, the greater the number of times of starting that is included in the state information.

The threshold value 400 relating to the number of times is set by the setting section 310 to be large in accordance with the magnitude of the activated time period, and the threshold value 410 relating to the time period is set by the setting section 310 to be large in accordance with the magnitude of the number of times of starting. Due thereto, state information of states in which the extent of deterioration of the battery 24 is low are excluded from the subject data. In other words, as illustrated in Fig. 6, even in a case in which the number of times of starting that is included in the state information is small, if the activated time period is long, that state information is considered to be that of the battery 24 that has a low extent of deterioration, and is excluded from the subject data. Further, even in a case in which the activated time period that is included in the state information is short, if the number of times of starting is large, similarly, that state information is considered to be that of the battery 24 that has a low extent of deterioration, and is excluded from the subject data.

The judging section 320A compares the number of times of starting and the activated time period that are included in the state information with the threshold value 400 relating to the number of times and the threshold value 410 relating to the time period that were set by the setting section 310, and judges whether or not a predetermined condition is satisfied. For example, the judging section 320A judges whether or not the number of times of starting that is included in the state information is greater than or equal to the threshold value 400 relating to the number of times, and, if the number of times is greater than or equal to the threshold value 400 relating to the number of times, the judging section 320A judges that a predetermined condition is satisfied. Further, the judging section 320A judges whether or not the activated time period included in the state information is greater than or equal to the threshold value 410 relating to the time period, and if the time period is greater than or equal to the threshold value 410 relating to the time period, the judging section 320A judges that a predetermined condition is satisfied.

If it is judged by the judging section 320A that a predetermined condition is satisfied, the outputting section 330 outputs the state information as subject data.

The storing section 340A stores the state information that was outputted as subject data, and the acquired state information, respectively.

### (Flow of Control)

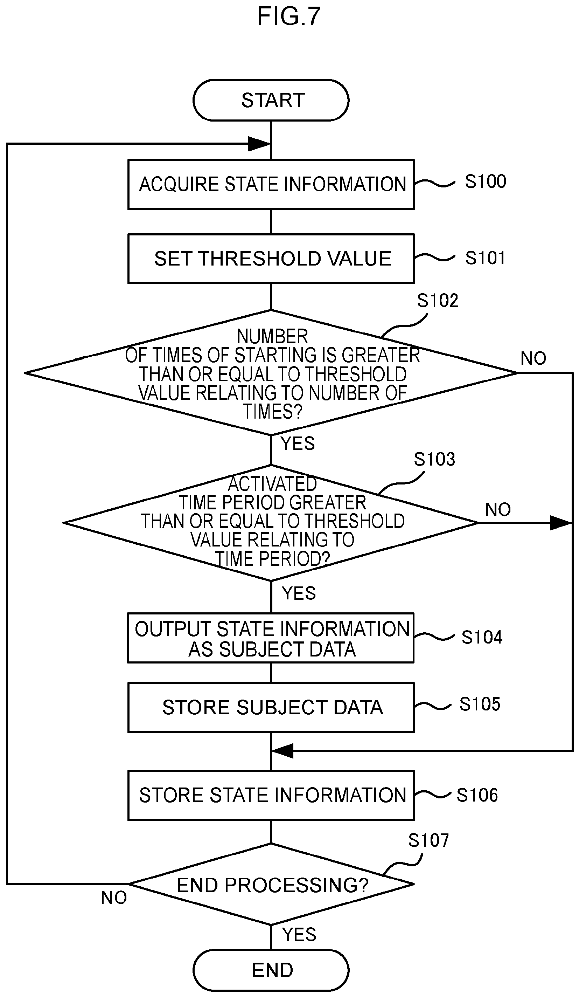

The flow of the respective processings executed at the information processing system 10 of the present embodiment is described by using the flowchart of Fig. 7. The respective processings at the central server 30 are executed due to the CPU 30A of the central server 30 functioning as the setting section 310, the judging section 320A, the outputting section 330, and the storing section 340A. The processing that extracts state information and is illustrated in Fig. 7 is executed, for example, in a case in which an instruction to extract state information is inputted.

In step S100, the CPU 30A acquires state information including the number of times of starting per one month and the activated time period per one month relating to the vehicle 12.

In step S101, by using the state information, the CPU 30A sets the threshold value 400 relating to the number of times and the threshold value 410 relating to the time period.

In step S102, the CPU 30A judges whether or not the number of times of starting that is included in the state information is greater than or equal to the threshold value 400 relating to the number of times. If the number of times of starting is greater than or equal to the threshold value 400 relating to the number of times (step S102: YES), the CPU 30A moves on to step S103. On the other hand, if the number of times of starting is not greater than or equal to the threshold value 400 relating to the number of times (i.e., if the number of times of starting is less than the threshold value 400 relating to the number of times) (step S102: NO), the CPU 30A moves on to step S106.

In step S103, the CPU 30A judges whether or not the activated time period that is included in the state information is greater than or equal to the threshold value 410 relating to the time period. If the activated time period is greater than or equal to the threshold value 410 relating to the time period (step S103: YES), the CPU 30A moves on to step S104. On the other hand, if the activated time period is not greater than or equal to the threshold value 410 relating to the time period (i.e., if the activated time period is less than the threshold value 410 relating to the time period) (step S103: NO), the CPU 30A moves on to step S106.

In step S104, the CPU 30A outputs state information as subject data.

In step S105, the CPU 30A stores the state information that was outputted as subject data.

In step S106, the CPU 30A stores the state information that was acquired.

In step S107, the CPU 30A judges whether or not to end the processing of extracting the state information. If the processing of extracting the state information is to be ended (step S107: YES), the CPU 30A ends the processing of extracting the state information. On the other hand, if the processing of extracting the state information is not to be ended (step S107: NO), the CPU 30A moves on to step S100, and acquires state information.

### (Overview of First Embodiment)

The central server 30 that serves as the information processing device of the present embodiment acquires state information that includes the number of times of starting per one month and the activated time period per one month relating to the vehicle 12, and, by using the state information, sets the threshold value 400 relating to the number of times and the threshold value 410 relating to the time period. In a case in which the number of times of starting that is included in the state information is greater than or equal to the threshold value 400 relating to the number of times, and the activated time period that is included in the state information is greater than or equal to the threshold value 410 relating to the time period, the central server 30 outputs and stores that state information as subject data.

As described above, in accordance with the present embodiment, computing costs can be suppressed when estimating the state of a battery.

Note that the above embodiment describes a form in which, in a case in which the condition that the number of times of starting is greater than or equal to the threshold value 400 relating to the number of times, and the activated time period is greater than or equal to the threshold value 410 relating to the time period, is satisfied, that state information is outputted as the subject data. However, the present disclosure is not limited to this. For example, under the condition of only that the number of times of starting is greater than or equal to the threshold value 400 relating to the number of times, that state information may be outputted as the subject data. Or, for example, under the condition of only that the activated time period is greater than or equal to the threshold value 410 relating to the time period, that state information may be outputted as the subject data.

Further, the present embodiment describes a form in which the threshold value 400 relating to the number of times and the threshold value 410 relating to the time period are linear. However, the present disclosure is not limited to this. The threshold value 400 relating to the number of times and the threshold value 410 relating to the time period may be non-linear. Or, any threshold values may be used provided that the values thereof increase in accordance with the number of times of starting and the activated time period.

Further, the present embodiment describes a form in which the respective threshold values are set in accordance with the number of times of starting and the activated time period that are included in the state information. However, the present disclosure is not limited to this, and the threshold values may be set per vehicle type.

### [Second Embodiment]

The first embodiment describes a form in which state information is extracted by using the number of times of starting and the activated time period that are included in the state information. The second embodiment describes a form in which state information is extracted by using the lowest voltages that are included in the state information.

Note that the structure of the information processing system (see Fig. 1), the example of the hardware structures of the vehicle 12 (see Fig. 2), the example of the functional structures of the onboard device 20 (see Fig. 3), the example of the hardware structures of the central server 30 (see Fig. 4) and the graph illustrating the threshold values (see Fig. 6) relating to the present embodiment are similar to those of the first embodiment, and therefore, description thereof is omitted. Points that differ from the first embodiment are described hereinafter. Further, the same structures are denoted by the same reference numerals, and description thereof is omitted.

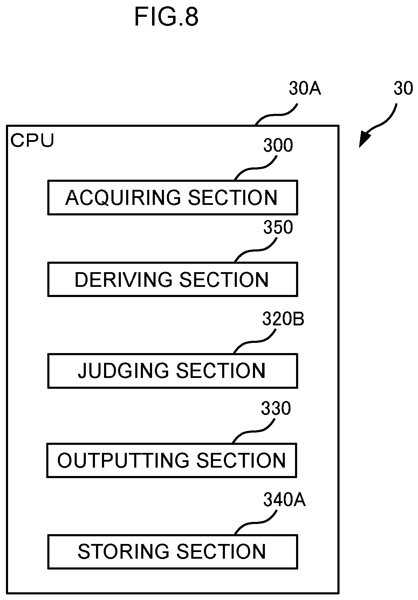

As illustrated in Fig. 8, at the central server 30 of the present embodiment, due to the CPU 30A executing the information processing program 120, the CPU 30A functions as the acquiring section 300, a deriving section 350, a judging section 320B, the outputting section 330 and the storing section 340A.

The deriving section 350 derives an index expressing the degree of dispersion in the lowest voltages (hereinafter called "index") by using the lowest voltages of the battery 24 that are included in the acquired state information. For example, the deriving section 350 derives a difference squared value, which is obtained by squaring the difference value between the lowest voltage actually outputted by the battery and the lowest voltage outputted the previous time in the starting of the vehicle 12 (the starting of the engine or the starting of the motor or the like) of two successive times, and derives, as the index, the cumulative value obtained by totaling the difference squared values of the most recent five times from the present point in time.

Here, when deterioration of the battery 24 advances, the charge capacity and the allowable charge amount and the like of the battery 24 decrease, and the voltage that is outputted becomes unstable. Therefore, when the lowest voltages outputted by the battery 24 in the starting of the vehicle 12 of two successive times are compared, the difference in the lowest voltages will be great at the battery 24 at which deterioration has advanced. Further, because there are cases in which the difference in the lowest voltages incidentally becomes large, in the present embodiment, by judging the degree of dispersion in the lowest voltages by using a cumulative value obtained by adding-up plural difference values, the state information is judged while taking the inclusion of incidental data into consideration.

Note that the present embodiment describes a form in which the difference values of the most recent five times are totaled. However, the present disclosure is not limited to this. Difference values of the most recent three times or of the most recent seven times may be added-up, or the difference squared value of any number of times may be added-up. Further, the present embodiment describes a form in which the difference squared value, which is obtained by squaring the values that are the differences, is derived. However, the present disclosure is not limited to this. For example, the absolute value of the difference value may be derived. Or, the mean squared error may be derived by squaring the difference value between the average value of past lowest voltages and an acquired lowest voltage. Or, the variance of the lowest voltages may be derived. Any value may be derived provided that the derived value is a positive number.

The judging section 320B compares the derived cumulative value and a predetermined threshold value, and judges whether or not a predetermined condition is satisfied. For example, the judging section 320B judges whether or not the cumulative value is greater than or equal to the predetermined threshold value (e.g., whether or not the cumulative value is greater than or equal to 5), and, if the cumulative value is greater than or equal to the predetermined threshold value, the judging section 320B judges that a predetermined condition is satisfied. Here, the predetermined threshold value is an example of the "third threshold value".

### (Flow of Control)

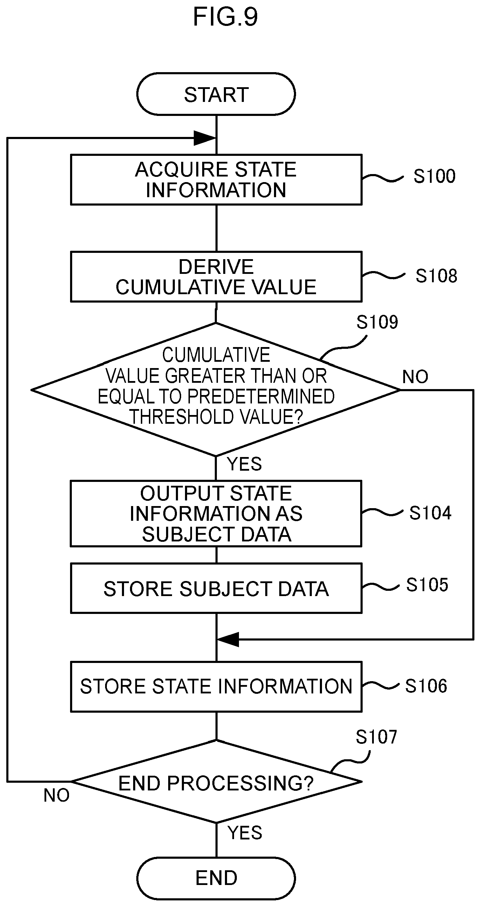

The flow of the respective processings executed at the information processing system 10 of the present embodiment are described by using the flowchart of Fig. 9. The respective processings at the central server 30 are executed due to the CPU 30A of the central server 30 functioning as the acquiring section 300, the deriving section 350, the judging section 320B, the outputting section 330, and the storing section 340A. The processing that extracts state information and is illustrated in Fig. 9 is executed, for example, in a case in which an instruction to extract state information is inputted. Note that steps that are the same as those of the extracting processing illustrated in Fig. 7 are denoted by the same step numbers as in Fig. 7, and description thereof is omitted.

In step S108, by using the lowest voltages included in the acquired state information, the CPU 30A derives the difference squared value of the lowest voltages relating to the starting of the vehicle 12 of two successive times, and derives a cumulative value that is obtained by totaling the difference squared values of the most recent five times.

In step S109, the CPU 30A judges whether or not the derived cumulative value is greater than or equal to a predetermined threshold value. If the cumulative value is greater than or equal to the predetermined threshold value (step S109: YES), the CPU 30A moves on to step S104. On the other hand, if the cumulative value is not greater than or equal to the predetermined threshold value (i.e., if the cumulative value is less than the predetermined threshold value) (step S109: NO), the CPU 30A moves on to step S106.

### (Overview of Second Embodiment)

The central server 30 that serves as the information processing device of the present embodiment acquires, as state information, the lowest voltages of the battery 24 per one month that relate to the vehicle 12, and, by using the state information, derives a cumulative value relating to the lowest voltages as an index. In a case in which the cumulative value is greater than or equal to a predetermined threshold value, the central server 30 outputs and stores that state information as subject data.

As described above, in accordance with the present embodiment, state information can be extracted while taking into consideration unstable states of the battery.

Note that the present embodiment describes a form in which the state of the battery is estimated by using only the degree of dispersion of lowest voltages as an index. However, the present disclosure is not limited to this. The state of the battery may be estimated by using any of plural combinations of the activated time period and number of times of starting relating to the first embodiment and the index relating to the second embodiment.

### [Third Embodiment]

The second embodiment describes a form in which state information is extracted by using an index derived from acquired state information. The third embodiment describes a form in which state information is extracted by using a learned model on which machine learning for extracting state information has been carried out.

Note that the structure of the information processing system (see Fig. 1), the example of the hardware structures of the vehicle 12 (see Fig. 2), the example of the functional structures of the onboard device 20 (see Fig. 3), the example of the hardware structures of the central server 30 (see Fig. 4) and the graph illustrating the threshold values (see Fig. 6) relating to the present embodiment are similar to those of the first embodiment, and therefore, description thereof is omitted. Points that differ from the first embodiment are described hereinafter. Further, the same structures are denoted by the same reference numerals, and description thereof is omitted.

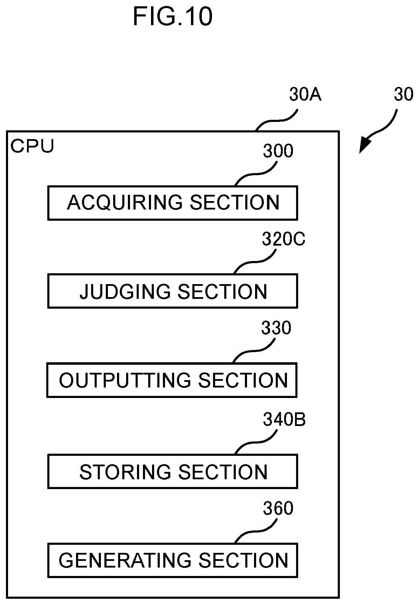

As illustrated in Fig. 10, at the central server 30 of the present embodiment, due to the CPU 30A executing the information processing program 120, the CPU 30A functions as the acquiring section 300, a judging section 320C, the outputting section 330, a storing section 340B and a generating section 360.

The judging section 320C extracts state information that is to be used as the subject, by using a learned model on which machine learning for extracting state information has been carried out. For example, the learned model is a classification model on which has been carried out machine learning for classifying the suitability of state information as subject data, i.e., whether or not the state information corresponds to subject data, by using state information that includes numbers of times of starting, activated time periods and lowest voltages that were acquired as learning data in the past, and the suitabilities of these state information as subject data.

The judging section 320C inputs the acquired state information into the learned model, and, in accordance with the suitability as subject data that is judged by the learned model, judges whether or not the state information satisfies a predetermined condition. For example, in a case in which the learned model judges that inputted state information corresponds to subject data, the judging section 320C judges that a predetermined condition has been satisfied.

Note that a form is described in which the learned model relating to the present embodiment is a classification model. However, the present disclosure is not limited to this. The learned model may be a regression model, or may be a neural network model. For example, the learned model that is a regression model may derive the threshold value 400 relating to the number of times and the threshold value 410 relating to the time period, and may judge whether or not the state information satisfies a predetermined condition. Further, the learned model that is a neural network model may derive a cumulative value that relates to the lowest voltages as an index, and may judge whether or not the cumulative value satisfies a predetermined condition.

The storing section 340B stores the state information that serves as the subject data and the state information that is acquired. Further, the storing section 340B stores the learned model that is generated by the generating section 360 that is described later. Here, the storing section 340B stores the judged suitability of the state information as subject data, in association with the state information.

The generating section 360 executes machine learning by using state information acquired in the past, and generates the learned model.

### (Flow of Control)

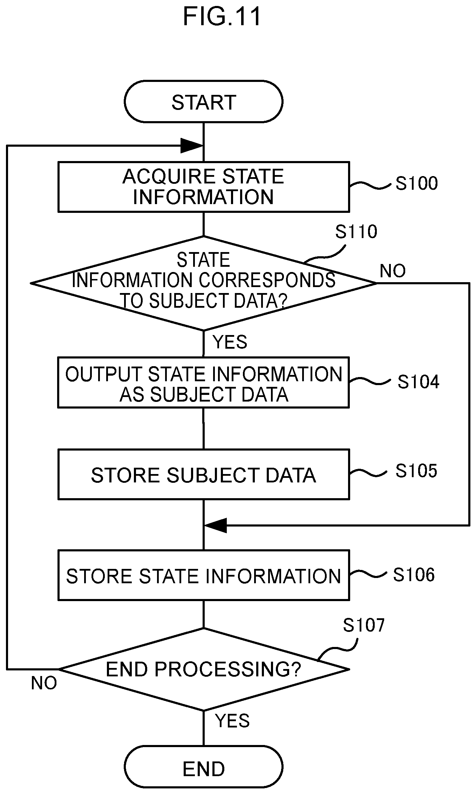

The flow of the respective processings executed at the information processing system 10 of the present embodiment is described by using the flowchart of Fig. 11. The respective processings at the central server 30 are executed due to the CPU 30A of the central server 30 functioning as the acquiring section 300, the judging section 320C, the outputting section 330, the storing section 340B and the generating section 360. The processing that extracts state information and is illustrated in Fig. 11 is executed, for example, in a case in which an instruction to extract state information is inputted. Note that, in Fig. 11, steps that are the same as those of the extracting processing illustrated in Fig. 7 are denoted by the same step numbers as in Fig. 7, and description thereof is omitted.

In step S110, the CPU 30A judges whether or not the state information that was inputted to the learned model corresponds to subject data. If the state information corresponds to subject data (step S110: YES), the CPU 30A moves on to step S104. On the other hand, if the state information does not correspond to subject data (i.e., if the state information is different than subject data) (step S110: NO), the CPU 30A moves on to step S106.

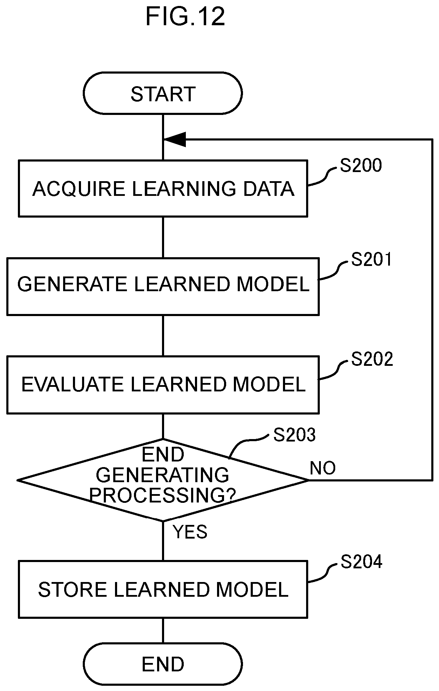

The processing of generating the learned model, which is executed by the information processing system 10 of the present embodiment, is described next by using the flowchart of Fig. 12. The generating processing illustrated in Fig. 12 is executed, for example, in a case in which an instruction to execute the processing of generating a learned model is inputted.

In step S200, the CPU 30A acquires, as learning data, state information including numbers of times of starting, activated time periods and lowest voltages that were acquired in the past, and suitabilities, as subject data, that correspond to the acquired state information.

In step S201, by using the acquired learning data, the CPU 30A executes machine learning and generates a learned model.

In step S202, the CPU 30A inputs state information to the learned model that was generated, and evaluates the learned model by using the suitability as subject data that is outputted from the learned model.

In step S203, the CPU 30A judges whether or not the processing of generating the learned model is to be ended. If the processing of generating the learned model is to be ended (step S203: YES), the CPU 30A moves on to step S204. On the other hand, if the processing of generating the learned model is not to be ended (step S203: NO), the CPU 30A moves on to step S200 and acquires learning data.

In step S204, the CPU 30A stores the learned model that was generated.

### (Overview of Third Embodiment)

The central server 30 that serves as the information processing device of the present embodiment extracts state information by using a learned model.

As described above, in accordance with the present embodiment, state information can be extracted while reflecting state information that was acquired in the past.

### [Notes]

Note that any of various types of processors other than a CPU may execute the various processings that are executed due to the CPU 20A and the CPU 30A reading-in software (programs) in the above-described embodiments. Examples of processors in this case include PLDs (Programmable Logic Devices) whose circuit structure can be changed after production such as FPGAs (Field-Programmable Gate Arrays) and the like, and dedicated electrical circuits that are processors having circuit structures that are designed for the sole purpose of executing specific processings such as ASICs (Application Specific Integrated Circuits) and the like, and the like. Further, the above-described respective processings may be executed by one of these various types of processors, or may be executed by a combination of two or more of the same type or different types of processors (e.g., plural FPGAs, or a combination of a CPU and an FPGA, or the like). Further, the hardware structures of these various types of processors are, more specifically, electrical circuits that combine circuit elements such as semiconductor elements and the like.

Further, in the above embodiments, the respective programs are described as being stored in advance (installed) on computer-readable, non-transitory recording media. For example, the collection program 100 at the onboard device 20 is stored in advance in the ROM 20B, and the information processing program 120 at the central server 30 is stored in advance in the storage 30D. However, the present disclosure is not limited to this, and the respective programs may be provided in forms of being recorded on a non-transitory recording medium such as a CD-ROM (Compact Disk Read Only Memory), a DVD-ROM (Digital Versatile Disk Read Only Memory), a USB (Universal Serial Bus) memory or the like. Further, the programs may be in forms of being downloaded from an external device via a network.

The flows of the processings described in the above embodiments are examples, and unnecessary steps may be deleted therefrom, new steps may be added thereto, or the order of processings may be rearranged, with a scope that does not depart from the invention which is defined in the claims.

## Claims

1. An information processing device (30) comprising:
an acquiring section (300) configured to acquire state information relating to a state of a battery installed in a vehicle;
a judging section (320A, 320B, 320C) configured to judge whether or not the acquired state information satisfies a predetermined condition relating to the battery; and
an outputting section (330) that is configured, in a case in which the state information satisfies the predetermined condition, to output the state information as a subject for diagnosing the battery, **characterized in that**:
(A) the acquiring section is configured to acquire the state information that includes a number of times of starting in which the vehicle was started and set in an on state, and an activated time period over which the vehicle was in the on state, and the judging section is configured to judge that the state information satisfies the predetermined condition when at least one of a case in which the number of times of starting relating to the state information is greater than or equal to a first threshold value (400), and a case in which the activated time period relating to the state information is greater than or equal to a second threshold value (410), is satisfied, wherein the first threshold value is set such that, the greater the activated time period included in the state information, the greater the first threshold value, and the second threshold value is set such that, the greater the number of times of starting included in the state information, the greater the second threshold value; and/or
(B) the acquiring section is configured to acquire, as the state information, lowest voltages outputted by the battery at times when the vehicle was started, and in a case in which an index, which expresses a degree of dispersion in the lowest voltages, is greater than or equal to a third threshold value, the judging section is configured to judge that the state information satisfies the predetermined condition.

2. The information processing device of claim 1, option B, wherein the judging section is configured to judge whether or not the predetermined condition is satisfied by using, as the index, a cumulative value obtained by totaling, for a predetermined number of times relating to starting of the vehicle, difference values respectively derived by squaring a difference between the lowest voltage the battery actually outputted and the lowest voltage outputted by the battery a previous time, in starting of the vehicle of two successive times.

3. The information processing device of claim 1, wherein the judging section includes a learned model that has been machine learned in order to judge suitability, as the subject, of the state information.

4. The information processing device of claim 3, further comprising a generating section that is configured to generate the learned model by executing machine learning by using, as learning data, the state information acquired in the past and suitabilities, as the subject, of the state information.

5. An information processing method in which a computer executes processings of:
acquiring (S100) state information relating to a state of a battery installed in a vehicle;
judging (S102, S103, S109, S110) whether or not the acquired state information satisfies a predetermined condition relating to the battery; and
in a case in which the state information satisfies the predetermined condition, outputting (S104) the state information as a subject for diagnosing the battery, **characterized in that**:
(A) the state information includes a number of times of starting in which the vehicle was started and set in an on state, and an activated time period over which the vehicle was in the on state, and the state information is judged to satisfy the predetermined condition when at least one of a case in which the number of times of starting relating to the state information is greater than or equal to a first threshold value (400), and a case in which the activated time period relating to the state information is greater than or equal to a second threshold value (410), is satisfied, wherein the first threshold value is set such that, the greater the activated time period included in the state information, the greater the first threshold value, and the second threshold value is set such that, the greater the number of times of starting included in the state information, the greater the second threshold value; and/or
(B) the state information includes lowest voltages outputted by the battery at times when the vehicle was started, and in a case in which an index, which expresses a degree of dispersion in the lowest voltages, is greater than or equal to a third threshold value, the state information is judged to satisfy the predetermined condition.

6. A computer-readable storage medium storing an information processing program for causing a computer to execute processings of:
acquiring (S100) state information relating to a state of a battery installed in a vehicle;
judging (S102, S103, S109, S110) whether or not the acquired state information satisfies a predetermined condition relating to the battery; and
in a case in which the state information satisfies the predetermined condition, outputting (S104) the state information as a subject for diagnosing the battery, **characterized in that**:
(A) the state information includes a number of times of starting in which the vehicle was started and set in an on state, and an activated time period over which the vehicle was in the on state, and the state information is judged to satisfy the predetermined condition when at least one of a case in which the number of times of starting relating to the state information is greater than or equal to a first threshold value (400), and a case in which the activated time period relating to the state information is greater than or equal to a second threshold value (410), is satisfied, wherein the first threshold value is set such that, the greater the activated time period included in the state information, the greater the first threshold value, and the second threshold value is set such that, the greater the number of times of starting included in the state information, the greater the second threshold value; and/or
(B) the state information includes lowest voltages outputted by the battery at times when the vehicle was started, and in a case in which an index, which expresses a degree of dispersion in the lowest voltages, is greater than or equal to a third threshold value, the state information is judged to satisfy the predetermined condition.

## Patentansprüche

1. Informationsverarbeitungsvorrichtung (30), die umfasst:
einen Erfassungsabschnitt (300), der so konfiguriert ist, dass er Zustandsinformationen erfasst, die sich auf den Zustand einer in einem Fahrzeug eingebauten Batterie beziehen;
einen Beurteilungsabschnitt (320A, 320B, 320C), der so konfiguriert ist, dass er beurteilt, ob die erfassten Informationen einen bestimmten Zustand in Bezug auf die Batterie erfüllen; und
einen Ausgabeabschnitt (330), der so konfiguriert ist, dass er in einem Fall, in dem die Informationen den bestimmten Zustand erfüllen, die Informationen als Grundlage für die Diagnose der Batterie ausgibt, **dadurch gekennzeichnet, dass**:
(A) der Erfassungsabschnitt so konfiguriert ist, dass er die Informationen über den Zustand erfasst, die eine Anzahl von Startvorgängen, bei denen das Fahrzeug gestartet und in einen eingeschalteten Zustand versetzt wurde, sowie eine Aktivierungsdauer, während der sich das Fahrzeug im eingeschalteten Zustand befand, enthalten, und der Beurteilungsabschnitt so konfiguriert ist, dass er beurteilt, dass die Informationen über den Zustand die vorgegebene Bedingung erfüllen, wenn mindestens einer der folgenden Fälle erfüllt ist: ein Fall, in dem die Anzahl der Startvorgänge in Bezug auf die Informationen über den Zustand größer oder gleich einem ersten Schwellenwert (400) ist, und ein Fall, in dem die Aktivierungsdauer in Bezug auf die Informationen über den Zustand größer oder gleich einem zweiten Schwellenwert (410) ist, wobei der erste Schwellenwert so festgelegt ist, dass der erste Schwellenwert umso größer ist, je länger die in den Informationen enthaltene Aktivierungsdauer ist, und der zweite Schwellenwert so festgelegt ist, dass der zweite Schwellenwert umso größer ist, je größer die Anzahl der Startvorgänge ist, die in den Informationen enthalten sind; und/oder
(B) der Erfassungsabschnitt so konfiguriert ist, dass er als Zustandsinformationen die niedrigsten Spannungen erfasst, die von der Batterie zu den Zeitpunkten ausgegeben wurden, zu denen das Fahrzeug gestartet wurde, und in einem Fall, in dem ein Index, der einen Streuungsgrad der niedrigsten Spannungen ausdrückt, größer oder gleich einem dritten Schwellenwert ist, der Beurteilungsabschnitt so konfiguriert ist, dass er beurteilt, dass die Informationen die vorbestimmte Bedingung erfüllen.

2. Informationsverarbeitungsvorrichtung nach Anspruch 1, Option B, wobei der Beurteilungsabschnitt so konfiguriert ist, dass er beurteilt, ob die vorgegebene Bedingung erfüllt ist, indem er als Index einen kumulativen Wert verwendet, der durch Summierung der Differenzwerte für eine vorgegebene Anzahl von Fahrzeugstarts erhalten wird, die jeweils durch Quadrieren der Differenz zwischen der tatsächlich von der Batterie ausgegebenen niedrigsten Spannung und der niedrigsten Spannung, die von der Batterie beim vorherigen Fahrzeugstart ausgegeben wurde, bei zwei aufeinanderfolgenden Fahrzeugstarts abgeleitet werden.

3. Informationsverarbeitungsvorrichtung nach Anspruch 1, wobei der Beurteilungsabschnitt ein trainiertes Modell enthält, das maschinell trainiert wurde, um die Eignung der Informationen über den Zustand als Gegenstand zu beurteilen.

4. Informationsverarbeitungsvorrichtung nach Anspruch 3, die ferner einen Erzeugungsabschnitt umfasst, der so konfiguriert ist, dass er das gelernte Modell erzeugt, indem er maschinelles Lernen unter Verwendung der in der Vergangenheit erfassten Zustandsinformationen und der Eignungen der Zustandsinformationen als Lerndaten ausführt.

5. Informationsverarbeitungsverfahren, bei dem ein Computer folgende Verarbeitungsschritte ausführt:
Erfassen (S100) von Zustandsinformationen bezüglich eines Zustands einer in einem Fahrzeug eingebauten Batterie;
Beurteilen (S102, S103, S109, S110), ob die erfassten Informationen einen vorbestimmten Bedingungssatz in Bezug auf die Batterie erfüllen; und
in einem Fall, in dem die Informationen den vorbestimmten Bedingungssatz erfüllen, Ausgeben (S104) der Informationen als Gegenstand für die Diagnose der Batterie, **dadurch gekennzeichnet, dass**:
(A) die Zustandsinformationen eine Anzahl von Startvorgängen, bei denen das Fahrzeug gestartet und in einen eingeschalteten Zustand versetzt wurde, sowie eine Aktivierungsdauer, während der sich das Fahrzeug im eingeschalteten Zustand befand, enthalten und die Zustandsinformationen beurteilt werden, dass sie die vorgegebene Bedingung erfüllen, wenn mindestens einer der folgenden Fälle erfüllt ist: ein Fall, in dem die Anzahl der Startvorgänge in Bezug auf die Informationen über den Zustand größer oder gleich einem ersten Schwellenwert (400) ist, und ein Fall, in dem die Aktivierungsdauer in Bezug auf die Informationen über den Zustand größer oder gleich einem zweiten Schwellenwert (410) ist, wobei der erste Schwellenwert so festgelegt ist, dass der erste Schwellenwert umso größer ist, je länger die in den Informationen enthaltene Aktivierungsdauer ist, und der zweite Schwellenwert so festgelegt ist, dass der zweite Schwellenwert umso größer ist, je größer die Anzahl der Startvorgänge ist, die in den Informationen enthalten sind; und/oder
(B) die Zustandsinformationen die niedrigsten Spannungen enthalten, die von der Batterie zu den Zeitpunkten ausgegeben wurden, zu denen das Fahrzeug gestartet wurde, und in einem Fall, in dem ein Index, der den Grad der Streuung der niedrigsten Spannungen ausdrückt, größer oder gleich einem dritten Schwellenwert ist, beurteilt wird, dass die Zustandsinformationen die vorbestimmte Bedingung erfüllen.

6. Computerlesbares Speichermedium, das ein Informationsverarbeitungsprogramm speichert, um einen Computer zu veranlassen, folgende Verarbeitungsschritte auszuführen:
Erfassen (S100) von Zustandsinformationen bezüglich eines Zustands einer in einem Fahrzeug eingebauten Batterie;
Beurteilen (S102, S103, S109, S110), ob die erfassten Informationen einen vorbestimmten Bedingungssatz in Bezug auf die Batterie erfüllen; und
in einem Fall, in dem die Informationen den vorbestimmten Bedingungssatz erfüllen, Ausgeben (S104) der Informationen als Gegenstand für die Diagnose der Batterie, **dadurch gekennzeichnet, dass**:
(A) die Zustandsinformationen eine Anzahl von Startvorgängen, bei denen das Fahrzeug gestartet und in einen eingeschalteten Zustand versetzt wurde, sowie eine Aktivierungsdauer, während der sich das Fahrzeug im eingeschalteten Zustand befand, enthalten und die Zustandsinformationen beurteilt werden, dass sie die vorgegebene Bedingung erfüllen, wenn mindestens einer der folgenden Fälle erfüllt ist: ein Fall, in dem die Anzahl der Startvorgänge in Bezug auf die Informationen über den Zustand größer oder gleich einem ersten Schwellenwert (400) ist, und ein Fall, in dem die Aktivierungsdauer in Bezug auf die Informationen über den Zustand größer oder gleich einem zweiten Schwellenwert (410) ist, wobei der erste Schwellenwert so festgelegt ist, dass der erste Schwellenwert umso größer ist, je länger die in den Informationen enthaltene Aktivierungsdauer ist, und der zweite Schwellenwert so festgelegt ist, dass der zweite Schwellenwert umso größer ist, je größer die Anzahl der Startvorgänge ist, die in den Informationen enthalten sind; und/oder
(B) die Zustandsinformationen die niedrigsten Spannungen enthalten, die von der Batterie zu den Zeitpunkten ausgegeben wurden, zu denen das Fahrzeug gestartet wurde, und in einem Fall, in dem ein Index, der den Grad der Streuung der niedrigsten Spannungen ausdrückt, größer oder gleich einem dritten Schwellenwert ist, beurteilt wird, dass die Zustandsinformationen die vorbestimmte Bedingung erfüllen.

## Revendications

1. Dispositif de traitement d'informations (30) comprenant :
une section d'acquisition (300) conçue pour acquérir des informations d'état relatives à un état d'une batterie installée dans un véhicule,
une section de jugement (320A, 320B, 320C) conçue pour juger si les informations d'état acquises satisfont ou non une condition prédéterminée relative à la batterie, et
une section de sortie (330) conçue, dans le cas où les informations d'état satisfont la condition prédéterminée, pour délivrer les informations d'état en tant que sujet de diagnostic de la batterie ; **caractérisé en ce que** :
(A) la section d'acquisition est conçue pour acquérir des informations d'état qui comprennent un nombre de démarrages concernant le nombre de fois que le véhicule a été démarré et mis à l'état activé, et une durée d'activation pendant laquelle le véhicule est resté activé, et la section de jugement est conçue pour juger que les informations d'état satisfont la condition prédéterminée lorsque le nombre de démarrages relatif aux informations d'état est supérieur ou égal à une première valeur seuil (400) et/ou lorsque la durée d'activation relative aux informations d'état est supérieure ou égale à une deuxième valeur seuil (410), la première valeur seuil étant réglée de telle façon que plus la durée d'activation comprise dans les informations d'état est grande, plus la première valeur seuil est grande, et la deuxième valeur seuil étant réglée de telle façon que plus le nombre de démarrages compris dans les informations d'état est grand, plus la deuxième valeur seuil est grande, et/ou
(B) la section d'acquisition est conçue pour acquérir, en tant qu'informations d'état, des tensions minimales délivrées par la batterie lors des démarrages du véhicule et, dans un cas où un indice qui exprime un degré de dispersion des tensions minimales est supérieur ou égal à une troisième valeur seuil, la section de jugement est conçue pour juger que les informations d'état satisfont la condition prédéterminée.

2. Dispositif de traitement d'informations selon la revendication 1, option B, dans lequel la section de jugement est conçue pour juger si la condition prédéterminée est satisfaite ou non à l'aide, en tant qu'indice, d'une valeur cumulative obtenue par totalisation, pour un nombre de démarrages prédéterminé du véhicule, de valeurs de différence respectivement dérivées en élevant au carré une différence entre la tension minimale de la batterie réellement délivrée et la tension minimale délivrée par la batterie une fois précédente, lors de deux démarrages du véhicule successifs.

3. Dispositif de traitement d'informations selon la revendication 1, dans lequel la section de jugement comprend un modèle appris qui a été appris automatiquement afin de juger l'aptitude, en tant que sujet, des informations d'état.

4. Dispositif de traitement d'informations selon la revendication 3, comprenant en outre une section de génération conçue pour générer le modèle appris par exécution d'un apprentissage automatique à l'aide, en tant que données d'apprentissage, des informations d'état acquises précédemment et des aptitudes, en tant que sujet, des informations d'état.

5. Procédé de traitement d'informations dans lequel un ordinateur exécute des traitements consistant à :
acquérir (S100) des informations d'état relatives à un état d'une batterie installée dans un véhicule,
juger (S102, S103, S109, S110) si les informations d'état acquises satisfont ou non une condition prédéterminée relative à la batterie, et
dans un cas où les informations d'états satisfont la condition prédéterminée, délivrer (S104) les informations d'état en tant que sujet de diagnostic de la batterie ; **caractérisé en ce que** :
(A) les informations d'état comprennent un nombre de démarrages concernant le nombre de fois que le véhicule a été démarré et mis à l'état activé, et une durée d'activation pendant laquelle le véhicule est resté activé, et les informations d'état sont jugées satisfaire la condition prédéterminée lorsque le nombre de démarrages relatif aux informations d'état est supérieur ou égal à une première valeur seuil (400) et/ou lorsque la durée d'activation relative aux informations d'état est supérieure ou égale à une deuxième valeur seuil (410), la première valeur seuil étant réglée de telle façon que plus la durée d'activation comprise dans les informations d'état est grande, plus la première valeur seuil est grande, et la deuxième valeur seuil étant réglée de telle façon que plus le nombre de démarrages compris dans les informations d'état est grand, plus la deuxième valeur seuil est grande, et/ou
(B) les informations d'état comprennent des tensions minimales délivrées par la batterie lors des démarrages du véhicule et, dans un cas où un indice qui exprime un degré de dispersion des tensions minimales est supérieur ou égal à une troisième valeur seuil, les informations d'état sont jugées satisfaire la condition prédéterminée.

6. Support de stockage lisible par ordinateur sur lequel est stocké un programme de traitement d'informations permettant d'amener un ordinateur à exécuter des traitements consistant à :
acquérir (S100) des informations d'état relatives à un état d'une batterie installée dans un véhicule,
juger (S102, S103, S109, S110) si les informations d'état acquises satisfont ou non une condition prédéterminée relative à la batterie, et
dans un cas où les informations d'état satisfont la condition prédéterminée, délivrer (S104) les informations d'état en tant que sujet de diagnostic de la batterie ; **caractérisé en ce que** :
(A) les informations d'état comprennent un nombre de démarrages concernant le nombre de fois que le véhicule a été démarré et activé, et une durée d'activation pendant laquelle le véhicule est resté activé, et les informations d'état sont jugées satisfaire la condition prédéterminée lorsque le nombre de démarrages relatif aux informations d'état est supérieur ou égal à une première valeur seuil (400) et/ou lorsque la durée d'activation relative aux informations d'état est supérieure ou égale à une deuxième valeur seuil (410), la première valeur seuil étant réglée de telle façon que plus la durée d'activation comprise dans les informations d'état est grande, plus la première valeur seuil est grande, et la deuxième valeur seuil étant réglée de telle façon que plus le nombre de démarrages compris dans les informations d'état est grand, plus la deuxième valeur seuil est grande, et/ou
(B) les informations d'état comprennent des tensions minimales délivrées par la batterie lors des démarrages du véhicule et, dans un cas où un indice qui exprime un degré de dispersion des tensions minimales est supérieur ou égal à une troisième valeur seuil, les informations d'état sont jugées satisfaire la condition prédéterminée.
